(19) Europäisches Patentamt
European Patent Office
Office européen des brevets

(11) EP 1 659 128 B1

# (12) EUROPEAN PATENT SPECIFICATION

(45) Date of publication and mention of the grant of the patent:
**24.03.2010 Bulletin 2010/12**

(21) Application number: **04772562.7**

(22) Date of filing: **25.08.2004**

(51) Int Cl.:
***C07F 9/53*** (2006.01) ***C09K 11/06*** (2006.01)
***C07F 5/00*** (2006.01)

(86) International application number:
**PCT/JP2004/012606**

(87) International publication number:
**WO 2005/021561 (10.03.2005 Gazette 2005/10)**

(54) **NOVEL OPTICALLY ACTIVE RARE EARTH COMPLEX EMITTING CIRCULARLY POLARIZED LIGHT**

NEUER OPTISCH AKTIVER SELTENERDKOMPLEX, DER CIRCULAR POLARISIERTES LICHT EMITTIERT

COMPLEXE DES TERRES RARES OPTIQUEMENT ACTIF A EMISSION DE LUMIERE POLARISEE CIRCULAIRE

(84) Designated Contracting States:
**FR GB**

(30) Priority: **26.08.2003 JP 2003301171**

(43) Date of publication of application:
**24.05.2006 Bulletin 2006/21**

(73) Proprietor: **DIC Corporation**
**Tokyo (JP)**

(72) Inventors:
- **NAGATA, Yoshiaki**
  **Sakura-shi, Chiba 285-0817 (JP)**
- **HASEGAWA, Yasuchika**
  **Toyonaka-shi, Osaka 560-0055 (JP)**
- **YANAGIDA, Shozo**
  **Kawanishi-shi, Hyogo 666-0133 (JP)**

(74) Representative: **Albrecht, Thomas**
**Kraus & Weisert**
**Patent- und Rechtsanwälte**
**Thomas-Wimmer-Ring 15**
**80539 München (DE)**

(56) References cited:
**WO-A-03/022857** **JP-A- 2003 327 590**
**US-A1- 2003 144 487**

- **HASEGAWA Y. ET AL.: 'Eu(hfa)3(BINAPO) no zenkaku undoryo o koryosita CD spectrum kaiseki' RAVE EARTHS no. 42, 2003, pages 132 - 133, XP002985725**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 659 128 B1

## Description

### Technical Field

The present invention relates to a new optically active rare earth complex which has excellent luminescence intensity and circularly polarized luminescence.

### Background Art

A rare earth complex is a luminous material which has high color purity and is a stable with respect to excitation. Accordingly, it can be used suitably for, for example, luminescent ink (for example, please refer to Japanese Examined Patent Application, Second Publication, No. Sho 54-22336) or an organic electroluminescence element (for example, please refer to Japanese Unexamined Patent Application, First Publication No. 2000-204363). Among them, for example, tris(3-trifluoroacetyl camphorate) europium and the like are known as a rare earth complexes which have circularly polarized luminescence (for example, please refer to J. Am. Chem. Soc., 98 (19), (1976), pp. 5858 to 5863). Here, circularly polarized luminescence means a luminescent property in which, for example, when a compound emits fluorescence or phosphorescence due to an exposure to an ultraviolet ray and the like, intensities between right circularly polarized light and left circularly polarized light of the fluorescence or phosphorescence emitted from the compound are different to each other. That is, circularly polarized luminescence means a property in which a following value "g" is not 0, when the intensity of the right circularly polarized light of the radiated fluorescence or phosphorescence is represented by $I_R$ and the intensity of the left circularly polarized light thereof is represented by $I_L$ and the value "g" is defined by the following formula.

$$g = \frac{I_L - I_R}{\frac{1}{2}(I_L + I_R)}$$

Light emitted from a compound having the property of circularly polarized luminescence can be used effectively, for example, when the compound is used for an organic electroluminescence element and the like (for example, please refer Japanese Unexamined Patent Application, First Publication No. 2002-151251.) . However, well-known rare earth complexes, for example, tris(3-trifluoroacetyl camphorate) europium and the like do not show sufficient luminescence intensity.

### Disclosure of the Invention

The present inventors studied extensively in order to solve the aforementioned problems, and obtained a new optically active rare earth complex and found that the complex had circularly polarized luminescence property and very strong luminescence intensity.

That is, the present invention provides an optically active rare earth complex represented by a following general formula (1).

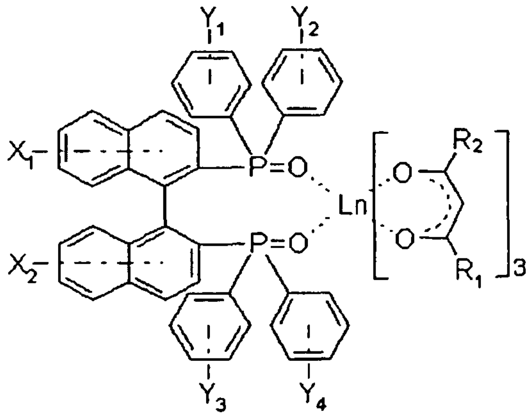

(1)

(In the formula, $X_1$ and $X_2$ each independently represents a hydrogen atom, a halogen atom, an alkyl group having 1 to 4 carbon atoms or alkoxy group having 1 to 4 carbon atoms; $Y_1$, $Y_2$, $Y_3$, and $Y_4$, each independently represents a hydrogen atom, a halogen atom, or alkyl group having 1 to 4 carbon atoms; $R_1$ represents an alkyl group having 1 to 8 carbon atoms, a fluorine-substituted alkyl group having 1 to 8 carbon atoms, or a phenyl group; and $R_2$ is a group selected from the group consisting of

(a) a cyclopentadienyl group (one $CH_2$ group existing in the cyclopentadienyl group may be replaced by -O- or -S-),
(b) a phenyl group (one or two CH groups existing in the phenyl group may be replaced by N), and
(c) a naphthyl group (one or two CH groups existing in the naphthyl group may be replaced by N),
the groups included in (a), (b), and (c) may be substituted with an alkyl group or a halogen atom; and
Ln represents a rare earth metal atom.)

Brief Description of Drawings

Fig. 1 is a fluorescence emission spectrum graph of S-A rare earth complex (7), S-A rare earth complex (9), and tris(3-trifluoroacetyl camphorate) europium as a comparative compound (manufactured by ALDRICH Corporation), and the comparison measurement was carried out in Evaluation Example 2.
Fig. 2 is a fluorescence emission spectrum graph of a S-A rare earth complex (13) and a S-A rare earth complex (18) as a comparative compound, and the comparison measurement was carried out in Evaluation Example 3.

Best Mode for Carrying Out the Invention

Hereafter, suitable examples of the present invention are explained, but the present invention is not limited thereto. For example, constituent elements of the examples may be combined with each other suitably.

The present invention provides a new optically active rare earth complex having a circularly polarized luminescence property wherein luminescence intensity of the complex is very high.

Optical purity (enantiomeric excess) of the compound represented by the general formula (1) of the present invention is preferably 70%ee or more, more preferably 80%ee or more, still further more preferably 90%ee or more, and most preferably 95%ee or more. Furthermore, in the general formula (1), $X_1$ and $X_2$ are preferably hydrogen atoms, $Y_1$, $Y_2$, $Y_3$, and $Y_4$ are preferably hydrogen atoms, and/or Ln is preferably Eu. Moreover, $R_1$ is preferably a trifluoromethyl group. It is also preferable that $R_2$ is a thienyl group. It is still more preferable that $R_1$ is a trifluoro methyl group and $R_2$ is a thienyl group.

Examples of the optically active rare earth complex represented by the general formula (1) (hereinafter, it is referred as a rare earth complex (1)) include a rare earth complex (1) which has the R-Δ structure represented by a general formula (1-1) (hereinafter, it is referred as a R-Δ rare earth complex (1)) and a rare earth complex (1) which has the S-A structure represented by a general formula (1-2) (hereinafter, it is referred as a S-A rare earth complex (1)). It is preferable that the amount of one of the two rare earth complexes (1) is larger than the other, and the optical purity is 90%ee or more.

General formula (1-1)

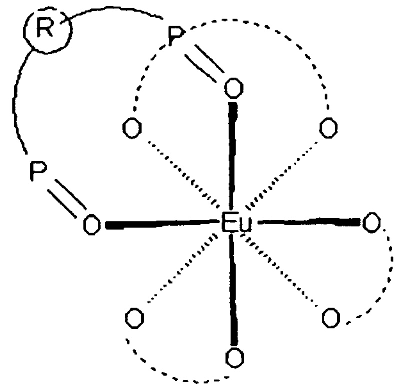

(1-1)

(In the general formula (1-1), each of the curved dotted lines represents a ligand represented by a following general formula (1-1a), and a curved solid line represents a ligand represented by a following general formula (1-1b).)

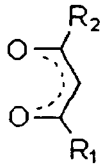

(1-1a)

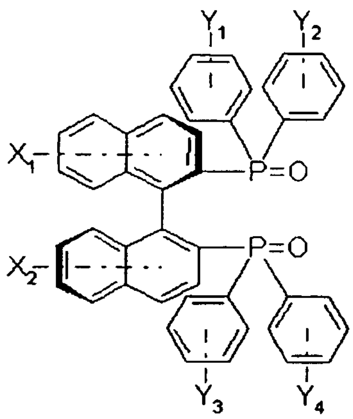

(1-1b)

General formula (1-2)

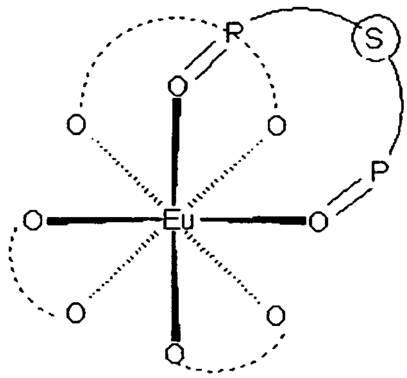

(1-2)

(In the general formula, each of the curved dotted line represents a ligand represented by the aforementioned general formula (1-1a), and a curved solid line represents a ligand represented by the following general formula (1-2b).)

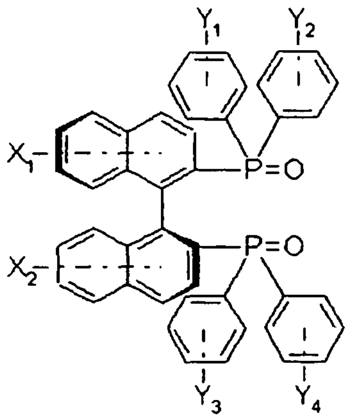

(1-2b)

The R-Δ structure and the S-A structure are an enantiomer of each other.

Generally, circularly polarized luminescence is emitted by a luminescence compound having optical activity, and if optical purity of the compound is increased, the polarization degree thereof is also increased.

Circularly polarized luminescence property is a property of radiating light in which, when a value "g" is defined by the following formula, and $I_R$ represents an intensity of right circularly polarized light of a fluorescence or phosphorescence radiated from a compound and $I_L$ represents an intensity of left circularly polarized light thereof, the value "g" is not 0.

$$g = \frac{I_L - I_R}{\frac{1}{2}(I_L + I_R)}$$

In the present invention, it is further preferable that the absolute value of "g" is 0.01 or more, and is more preferably 0.02 to 1.

In general, a rare earth complex has a coordinated structure of a regular quadrangular antiprism, and therefore, there are two types of stereoisomer based on an absolute configuration regarding the periphery of the rare earth metal atom. Hereinafter, the two isomers are distinguished from each other by using the signs "Δ" and "Λ" Due to the presence

of a stereoisomer, even if an optically active ligand is introduced into a rare earth complex, a complex compound having a high optical purity was not obtained. The reason is that the complex compound includes two stereoisomers of "Δ" and "Λ" and the stereoisomers may be included therein in an equivalent amount to each other.

As a result of studies, the present inventors found that an optically active rare earth complex having very high optical purity was able to be obtained by introducing a ligand which had a diastereo selectivity as an optically active ligand, and this complex had circularly polarized luminescence and had a very high luminescence intensity.

In the present invention, the ligand which has a diastereo selectivity is intended to be a ligand in which, when the ligand has two kinds of enantiomers (hereinafter, the enantiomers may be represented by an "R" form and an "S" form) and one enantiomer (for example, "R" form ligand) is used to form a complex with a rare earth, one type of stereoisomer (for example, a rare earth complex having a Δ form) is generated selectively. The ligand having a diastereo selectivity may have two or more kinds of stereoisomers.

Examples of a ligand having diastereo selectivity include a compound represented by the following general formula (2).

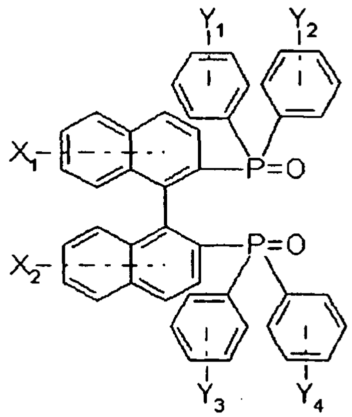

(2)

(In the general formula (2), $X_1$, $X_2$, $Y_1$, $Y_2$, $Y_3$ and $Y_4$ represent the same group and atom as those in general formula (1).) The above ligand is hereinafter referred as a ligand (2).

There are two kinds of optical isomers in the ligand (2), since the ligand (2) has axial asymmetry at the portion of a binaphtyl group thereof. Hereinafter, said two isomers are distinguished by using signs "R" and "S". When the ligand (2) is used, for example, the optically active rare earth complex represented by the following general formula (3) (hereinafter, it is represented by a rare earth complex (3)) can be obtained.

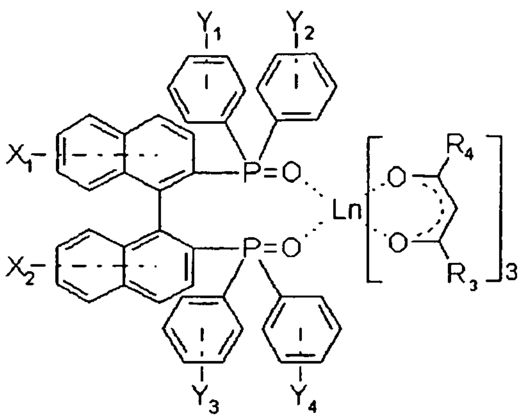

(3)

(In the general formula (3), $X_1$, $X_2$, $Y_1$, $Y_2$, $Y_3$ and $Y_4$ represent the same group and atom as those in the general formula (1). $R_3$ and $R_4$ each independently represents an alkyl group having 1 to 20 carbon atoms, a fluorine-substituted alkyl group having 1 to 20 carbon atoms, a hydroxyl group, a nitro group, an amino group, a sulfonyl group, a cyano group, a silyl group, a phosphonic acid group, a diazo group, a mercapto group, an aryl group, and a hetero aryl group.)

When an "R" form ligand was used as the ligand (2), a "Δ" form of the rare earth complex (3) (hereinafter, it is

cited as a R-Δ rare earth complex (3)) was formed selectively. Furthermore, when an "S" form ligand was used as the ligand (2), a "A" form of the rare earth complex (3) (hereinafter, it is cited as a R-A rare earth complex (3)) was formed selectively.

The rare earth complex (3) has circularly polarized luminescence. When luminescence intensity is taken into consideration, a compound represented by the following general formula (1) (a rare earth complex (1)) which is a new optically active rare earth complex of the present invention is preferable.

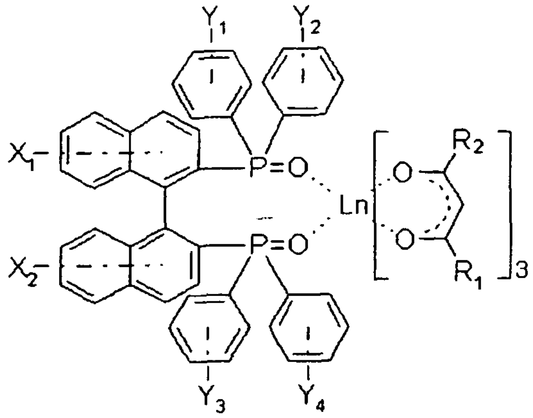

(1)

In the general formula (1), examples of substituents represented by $X_1$ and $X_2$ include each independently a hydrogen atom, a halogen atom such as a fluorine atom and a chlorine atom, an alkyl group such as a methyl group, an ethyl group, and an iso-propyl group, an alkoxy group such as a methoxy group, an ethoxy group, and a tert-butoxy group. Among them, a hydrogen atom is preferable as the substituents.

In the general formula (1), examples of substituents represented by $Y_1$, $Y_2$, $Y_3$, and $Y_4$ include each independently a hydrogen atom, a halogen atom such as a fluorine atom and a chlorine atom, an alkyl group such as a methyl group, an ethyl group, and an iso-propyl group. Among them, a hydrogen atom is preferable as the substituents. Furthermore, a group represented by $X_1$, $X_2$, $Y_1$, $Y_2$, $Y_3$, and/or $Y_4$ may be plural groups, and said plural groups may be the same or different to each other. For example, when $X_1$, $X_2$, $Y_1$, $Y_2$, $Y_3$, or $Y_4$ exists as plural groups, such plural groups may be the same or different to each other. Furthermore, $X_1$ and/or $X_2$ in the general formula (1) may be a group (s) bonding to either of two continuous benzene rings, or a group(s) bonding to both of the two continuous benzene rings when $X_1$ and/or $X_2$ are existing as plural groups.

Examples of a substituent represented by $R_1$ in the general formula (1) include a methyl group, a trifluoromethyl group, a pentafluoroethyl group, a hexafluoro isopropyl group, and a perfluorohexyl group. Among them, the trifluoro methyl group is preferable.

Examples of a substituent represented by $R_2$ in the general formula (1) include a phenyl group, a tolyl group, a fluorophenyl group, a pentafluorophenyl group, a trifluoromethyl phenyl group, a chlorophenyl group, a naphthyl group, a furyl group, a thienyl group, a thianthrenyl group, a pyranyl group, an isobenzofuranyl group, a pyrazolyl group, a pyridyl group, and a pyrazinyl group. Furthermore, examples thereof further include substituted groups which are the same as the aforementioned groups but further substituted with an alkyl group, an aryl group, an alkoxy group, an aryloxy group, a halogen atom, the alkoxycarbonyl group, a nitrile group, and/or a nitro group.
A preferable substituent represented by $R_2$ is a phenyl group, a tolyl group, a naphthyl group, a furyl group, and a thienyl group, and the thienyl group is more preferable.

Examples of a rare earth metal shown by Ln in the compound represented by the general formula (1) include each atom having an atomic number of 57 to 71, and a preferable rare earth metal is Eu or Yb.

As a forming method of the rare earth complex (1) of the present invention, for example, compounds represented by a following general formula (2) and a following general formula (4) can be stirred to react with each other in an organic solvent such as an alcohol and acetone at a temperature of -50 to 80°C, preferably 0 to 40°C, for 1 to 24 hours.

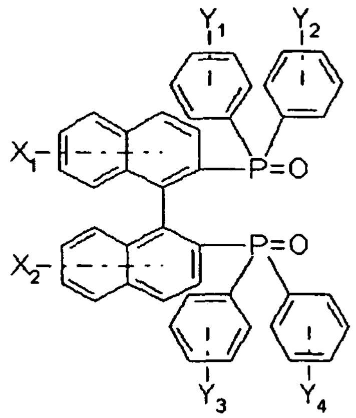

(2)

(In the general formula (2), $X_1$, $X_2$, $Y_1$, $Y_2$, $Y_3$ and $Y_4$ represent the same group and atom as those in the general formula (1).)

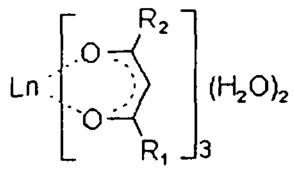

(4)

(In the general formula (4), Ln, $R_1$ and $R_2$ represent the same group and atom as those in the general formula (1).)

For example, the compound represented by the general formula (2) can be formed by a method described in Org. Synth., Coll. Vol. 8, 57 (1993). Furthermore, the compound represented by the general formula (4) can be formed by a method described in Japanese Patent Application No. 2003-143292, for example. After a reaction of the method, the rare earth complex (1) as a target material can be obtained due to solvent evaporation conducted subsequently to the reaction. If required, purification such as recrystallization may be conducted.

When the rare earth complex (1) of the present invention is used as a circularly polarized luminescent material, it is preferable that the rare earth complex (1) is used in the state where either of two kinds of optical isomers, a R-Δ rare earth complex (1) and a S-A rare earth complex (1), is excessively contained. The optical purity (enantiomer excess) of the compound represented by the general formula (1) of the present invention is preferably 70%ee or more, more preferably 80%ee or more, still further more preferably 90%ee or more, and most preferably 95%ee or more.

## Examples

The present invention is explained in detail below by using examples, but the present invention is not limited thereto. Hereinafter, "part" represents "part by mass".

### Example 1

2.60 parts of a complex of europium-thenoyltrifluoroacetonate represented by a following general formula (6), 2.00 parts of (S)-BINAPO represented by a following formula (5), and 75 parts of methanol were stirred for 2 hours at a room temperature to allow to react. After the reaction, the solvent was evaporated by using an evaporator, and a fine yellow powder was obtained. Due to recrystallization of the powder using ethanol, 2.91 parts of an optically active rare earth complex represented by a following general formula (7) (S-A form; hereinafter it may be described as a S-A rare earth complex (7)) was obtained.

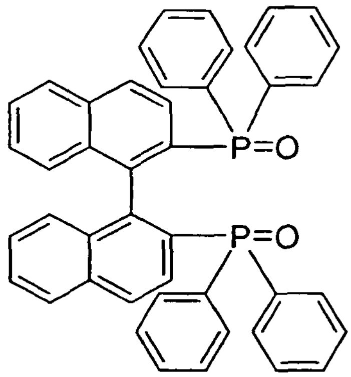

(5)

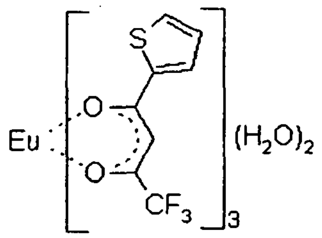

(6)

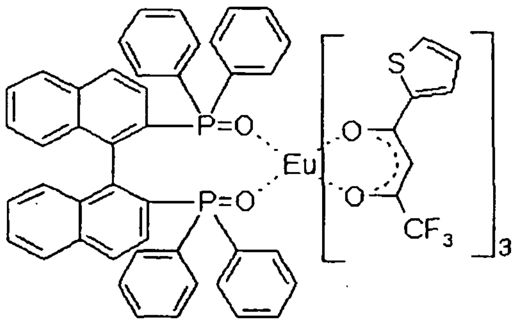

(7)

It was confirmed by following methods that the rare earth complex represented by the general formula (7) was generated as follow.
$^{1}H$ NMR ($d_6$-Acetone): d 5.12 (s), 6.44 (s), 6.71 (t), 6.89 (t), 7.18 (q), 7.23 (t), 7.30 (t), 7.63 (t), 7.76 (t), 7.89 (m), 8.05 (m), 8.31(t)
$^{31}P$ NMR ($d_6$-Acetone): d-67.47 (s)

| | |
|---|---|
| Elementary analysis | Measured value: C 57.19%, H 3.71 %, Eu 10.4% |
| | Calculated value: C 55.55%, H3.02%, Eu 10.3% |

Example 2

1.98 parts of (S)-BINAPO represented by the aforementioned general formula (5), 2.56 parts of a complex of europium-benzoyltrifluoroacetonate represented by a following general formula (8) and 70 parts of methanol were stirred for 2 hours at a room temperature to allow to react. After the reaction, the solvent was evaporated by using an evaporator, and a fine yellow powder was obtained. Due to recrystallization of the powder using ethanol, 2.12 parts of an optically

active rare earth complex represented by a following general formula (9) (S-Λ form; hereinafter it may be described as a S-A rare earth complex (9)) was obtained.

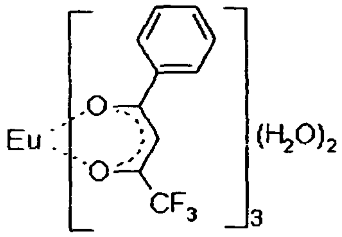

(8)

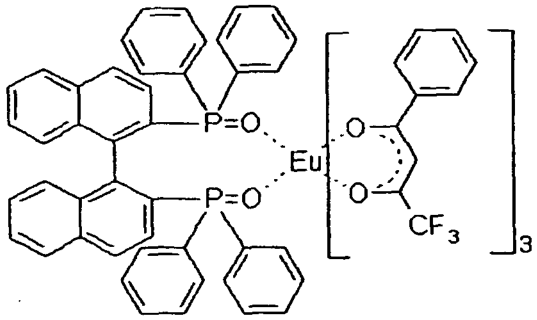

(9)

It was confirmed by following methods that the rare earth complex represented by the formula (9) was generated as follow.

$^{1}H$ NMR ($d_6$-Acetone): d 5.56 (s), 6.42 (s), 6.91 (t), 7.13 (m), 7.25 (d), 7.36 (t), 7.64 (s), 7.75 (t), 7.93 (m), 7.99 to 8.14(m)

$^{31}P$ NMR (d6-Acetone): d -62.55 (s)

| | |
|---|---|
| Elementary analysis | Measured value; C 60.92%, H 3.96%, Eu 10.3% |
| | Calculated value; C 61.21%, H 3.47%, Eu 10.5% |

Example 3

1.99 parts of (S)-BINAPO represented by the aforementioned general formula (5), 3.00 parts of a complex of europium-naphthoyltrifluoroacetonate represented by a following general formula (10) and 70 parts of acetone were stirred for 2 hours at a room temperature to allow to react. After the reaction, the solvent was evaporated by using an evaporator, and a fine yellow powder was obtained. Due to recrystallization of the powder using ethanol, 2.12 parts of an optically active rare earth complex shown by a following general formula (11) (S-A form; hereinafter it may be described as a S-A rare earth complex (11)) was obtained.

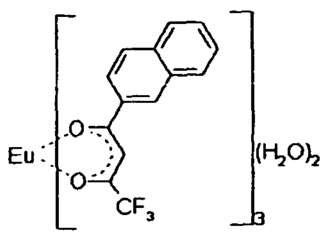

(10)

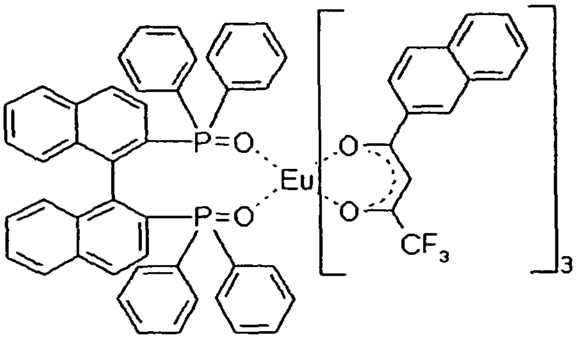

(11)

It was confirmed by following methods that the rare earth complex represented by the general formula (11) was generated as follow.
$_1$H NMR (d6-Acetone): d 5.91 (s), 6.44 (s), 6.87 (t), 7.07 (m), 7.13 to 7.29 (m), 7.42 to7.47 (m), 7.61 (t), 7.76 (t), 7.94 (m), 8.01 to 8.22 (m)
$_{31}$P NMR (d6-Acetone): d -64.25 (s)

| | |
|---|---|
| Elementary analysis | Measured value: C 63.74%, H 3.51%, Eu 9.4% |
| | Calculated value: C 63.05%, H 3.69%, Eu 9.3% |

Example 4

2.00 parts of (S)-BINAPO represented by a general formula (5), 2.68 parts of a complex of ytterbium-thenoyltrifluoroacetonate represented by a following general formula (12) and 50 parts of acetone were stirred for 2 hours at a room temperature to allow to react. After the reaction, the solvent was evaporated by using an evaporator, and a fine yellow powder was obtained. Due to recrystallization of the powder using ethanol, 1.27 parts of optically active rare earth complex represented by a following general formula (13) (S-A form; hereinafter it may be described as a S-A rare earth complex (13)) was obtained.

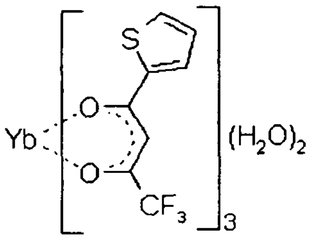

(12)

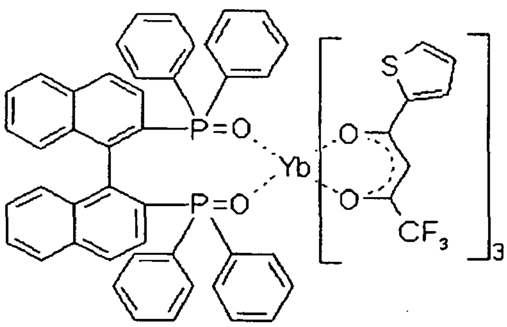

(13)

It was confirmed by a following method that the rare earth complex represented by the general formula (11) was generating as follows.

| | |
|---|---|
| Elementary analysis | Measured value: C 53.01%, H 3.70%, Yb 11.4% |
| | Calculated value: C 53.48%, H 3.17%, Yb 11.3% |

Example 5

In the same manner as in Example 4 except that the complex represented by the general formula (12) was replaced with a complex of a ytterbium-benzoyltrifluoroacetonate represented by a following general formula (14), 2.14 parts of an optically active rare earth complex represented by a following general formula (15) (S-A form; henceforth it may be described as a S-A rare earth complex (15)) was obtained.

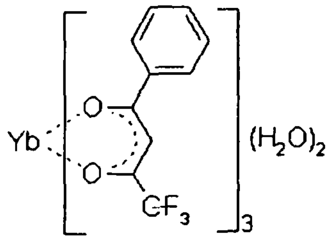

(14)

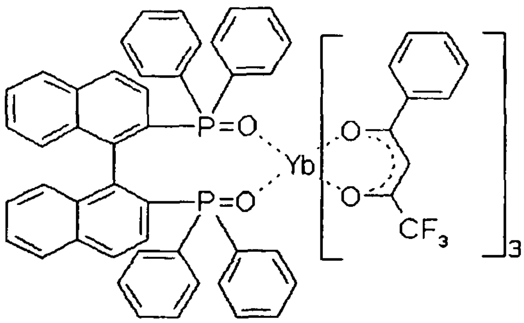

(15)

Example 6

In the same manner as in Example 4 except that the complex represented by the general formula (12) was replaced with a complex of ytterbium-naphthoyltrifluoroacetonate represented by a following general formula (16), 1.88 parts of an optically active rare earth complex represented by a following general formula (17) (S-A form; hereinafter it may be described as a S-A rare earth complex (17)) was obtained.

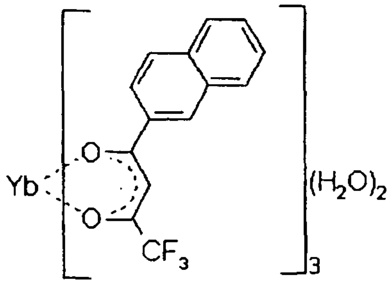

(16)

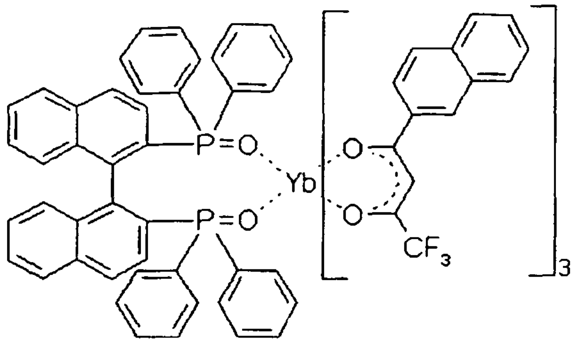

(17)

Examples 7 to 12

R-Δ rare earth complexes (7), (9), (11), (13), (15), and (17) were obtained by methods which were the same as those of Examples 1 to 6 except that (R)-BINAPO was used instead of (S)-BINAPO.

Comparative Example 1

An optically active rare earth complex represented by a following general formula (18) (S-A form; hereinafter it may be described as a S-A rare earth complex (18)) was obtained from a complex of a (S)-BINAPO and ytterbium-hexafluoroacetylacetonato according to a method described in Japanese Patent Application No. 2003-327590.

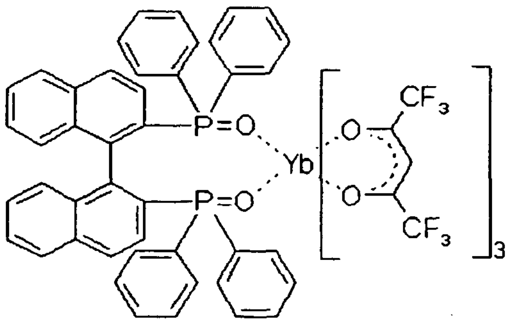

(18)

(Evaluation Example 1)

(Measurement of circularly polarized luminescence property)

0.1 part of a S-A rare earth complex (7) and 0.1 part of a S-A rare earth complex (9) were separately dissolved in 1 part of acetone, and circularly polarized luminescence property of the two solutions was evaluated by using a CPL-200 manufactured by JASCO Corporation. The g values thereof were -0.04 and -0.08 under conditions of light having a wavelength of 590 nm for luminescence.

(Evaluation Example 2)

(Evaluation of luminescence)

The S-A rare earth complex (7) and the S-A rare earth complex (9) of the present invention and a comparison compound: tris(3-trifluoroacetyl camphorate) europium (manufactured by ALDRICH Corporation) were prepared, and three solutions were formed wherein 0.1 part thereof was dissolved separately in five parts of acetone. Ultraviolet rays (about 365 nm) were irradiated on each solution by using a black light lamp.
Strong red luminescence of the solutions of the S-Λ rare earth complex (7) and the S-A rare earth complex (9) of the present invention was observed. Only very weak luminescence of the solution of the tris(3-trifluoroacetyl camphorate) europium was observed.

Each fluorescence luminescence intensity of the produced solutions was measured using a measuring apparatus F-4000 manufactured by Hitachi, Ltd.

Each luminescence intensity when the solutions are excited due to light having wavelength of 410 nm is shown in Fig. 1. There was a large difference of luminescence intensity between the optically active rare earth complexes of the present invention and the comparison compound (tris(3-trifluoro acetyl camphorate) europium).

(Evaluation Example 3)

In the same manner as the evaluation example 2, the S-A rare earth complex (13) of the present invention and the comparison compound: S-A rare earth complex (18) were prepared, and two solutions were formed wherein 0.1 part of the complexes was dissolved separately in five parts of acetone. Since both of the complexes emits light in a wavelength range of 900 nm or more (infrared region), comparison between the fluorescence luminescence intensities of the two solutions was conducted by using a spectrofluorometer: FLUOROLOG-3 system manufactured by SPEX corporation, since the spectrofluorometer can correspond to the measurement for such a wavelength range. Each luminescence intensity when an excitation occurred in a wavelength at which the maximum value of an excitation spectrum was able to be provided (S-A rare earth complex (13) of the present invention: 405nm, S-A rare earth complex (18): 366 nm) is shown in Fig. 2. The optically active rare earth complex of the present invention had a larger luminescence intensity compared with the comparison compound: S-A rare earth complex (18).

Industrial Applicability

According to the present invention, an optically active rare earth complex can be provided wherein the complex has circularly polarized luminescence and luminescence intensity thereof is very large as compared with the conventional optically active rare earth complex.

The optically active rare earth complex of the present invention, which has the circularly polarized luminescence, has high color purity, and luminescence intensity thereof is very high. Therefore, the light emitted can be used effectively, and the optically active rare earth complex can be used suitably for luminescent ink or an organic electroluminescence element.

## Claims

1. An optically active rare earth complex represented by a general formula (1):

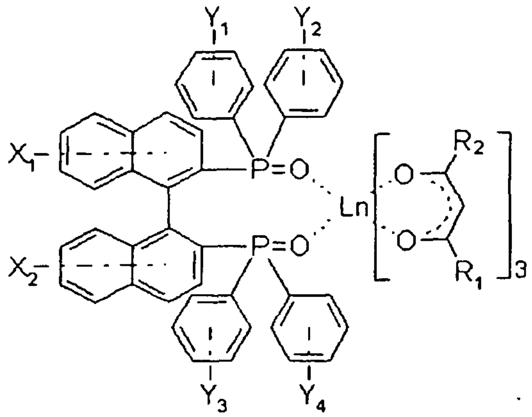

(1)

(in the formula (1), $X_1$ and $X_2$ each independently represents a hydrogen atom, a halogen atom, an alkyl group having 1 to 4 carbon atoms or alkoxy group having 1 to 4 carbon atoms; $Y_1$, $Y_2$, $Y_3$, and $Y_4$, each independently represents a hydrogen atom, a halogen atom, or an alkyl group having 1 to 4 carbon atoms; $R_1$ represents an alkyl group having 1 to 8 carbon atoms, a fluorine-substituted alkyl group having 1 to 8 carbon atoms, or a phenyl group; and $R_2$ is a group selected from the group consisting of;

(a) a cyclopentadienyl group (one $CH_2$ group existing in the cyclopentadienyl group may be replaced by -O- or -S-),
(b) a phenyl group (one or two CH groups existing in the phenyl group may be replaced by N), and
(c) a naphthyl group (one or two CH groups existing in the naphthyl group may be replaced by N), and

the groups included in (a), (b), and (c) may be substituted with an alkyl group or a halogen atom; and Ln represents a rare earth metal atom).

2. The optically active rare earth complex according to claim 1, wherein $X_1$ and $X_2$ in the general formula (1) are hydrogen atoms.

3. The optically active rare earth complex according to claim 1, wherein $Y_1$, $Y_2$, $Y_3$, and $Y_4$ in the general formula (1) are hydrogen atoms.

4. The optically active rare earth complex according to claim 1, wherein Ln in the general formula (1) is one of Eu and Yb.

5. The optically active rare earth complex according to claim 1, wherein $R_1$ in the general formula (1) is a trifluoromethyl group.

6. The optically active rare earth complex according to claim 1, wherein $R_2$ in the general formula (1) is a thienyl group.

7. The optically active rare earth complex according to claim 1, wherein an optical purity of the compound represented by the general formula (1) is 70%ee or more.

8. The optically active rare earth complex according to claim 1, wherein an optical purity of the compound represented by the general formula (1) is 90%ee or more.

**Patentansprüche**

1. Optisch aktiver Seltenerdkomplex, verkörpert durch die allgemeine Formel (I):

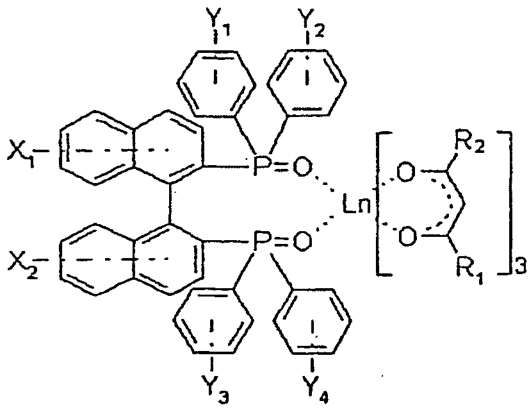

(1)

(in Formel (1) stellen $X_1$ und $X_2$ jeweils unabhängig ein Wasserstoffatom, ein Halogenatom, eine Alkylgruppe mit 1 bis 4 Kohlenstoffatomen oder eine Alkoxygruppe mit 1 bis 4 Kohlenstoffatomen dar; $Y_1$, $Y_2$, $Y_3$ und $Y_4$ stellen jeweils unabhängig ein Wasserstoffatom, ein Halogenatom oder eine Alkylgruppe mit 1 bis 4 Kohlenstoffatomen dar; $R_1$ stellt eine Alkylgruppe mit 1 bis 8 Kohlenstoffatomen, eine fluorsubstituierte Alkylgruppe mit 1 bis 8 Kohlenstoffatomen, oder eine Phenylgruppe dar; und $R_2$ ist eine Gruppe, ausgewählt aus der Gruppe, bestehend aus

(a) einer Cyclopentadienylgruppe (eine in der Cyclopentadienylgruppe vorhandene $CH_2$-Gruppe kann durch -O- oder -S- ersetzt sein),
(b) einer Phenylgruppe (eine oder zwei in der Phenylgruppe vorhandene CH-Gruppen können durch N ersetzt sein), und
(c) einer Naphthylgruppe (eine oder zwei in der Naphthylgruppe vorhandene CH-Gruppen können durch N ersetzt sein), und
die in (a), (b) und (c) enthaltenen Gruppen können mit einer Alkylgruppe oder einem Halogenatom substituiert werden; und Ln stellt ein Seltenerdmetallatom dar).

2. Optisch aktiver Seltenerdkomplex gemäß Anspruch 1, wobei $X_1$ und $X_2$ in der allgemeinen Formel (1) Wasserstoffatome sind.

3. Optisch aktiver Seltenerdkomplex gemäß Anspruch 1, wobei $Y_1$, $Y_2$, $Y_3$ und $Y_4$ in der allgemeinen Formel (1) Wasserstoffatome sind.

4. Optisch aktiver Seltenerdkomplex gemäß Anspruch 1, wobei Ln in der allgemeinen Formel (1) eines aus Eu und Yb ist.

5. Optisch aktiver Seltenerdkomplex gemäß Anspruch 1, wobei $R_1$ in der allgemeinen Formel (1) eine Trifluormethylgruppe ist.

6. Optisch aktiver Seltenerdkomplex gemäß Anspruch 1, wobei $R_2$ in der allgemeinen Formel (1) eine Thienylgruppe ist.

7. Optisch aktiver Seltenerdkomplex gemäß Anspruch 1, wobei die optische Reinheit der durch die allgemeine Formel (1) dargestellten Verbindung 70%ee oder mehr beträgt.

8. Optisch aktiver Seltenerdkomplex gemäß Anspruch 1, wobei die optische Reinheit der durch die allgemeine Formel (1) dargestellten Verbindung 90%ee oder mehr beträgt.

## Revendications

1. Complexe des terres rares optiquement actif représenté par la formule générale (1):

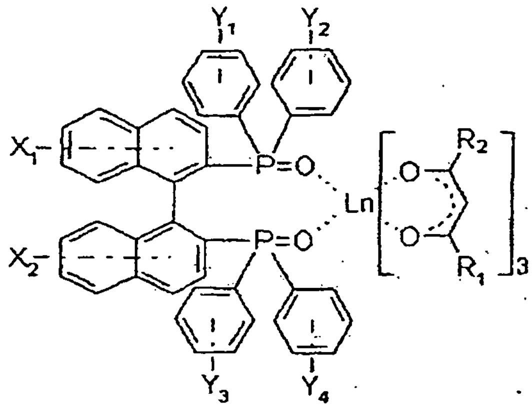

(1)

(dans la formule (1): $X_1$ et $X_2$ représentent chacun indépendamment un atome d'hydrogène, un atome d'halogène, un groupe alkyle ayant de 1 à 4 atomes de carbone ou un groupe alcoxyle ayant de 1 à 4 atomes de carbone; $Y_1$, $Y_2$, $Y_3$ et $Y_4$ représentent chacun indépendamment un atome d'hydrogène, un atome d'halogène ou un groupe alkyle ayant de 1 à 4 atomes de carbone; $R_1$ représente un groupe alkyle ayant de 1 à 8 atomes de carbone, un groupe alkyle, substitué par fluor et ayant de 1 à 8 atomes de carbone, ou un groupe phényle, et $R_2$ est un groupe choisi parmi le groupe consistant en:

(a) un groupe cyclopentadiényle (un groupe $CH_2$ présent dans le groupe cyclopentadiényle peut être remplacé par -O- ou -S-),
(b) un groupe phényle (un ou deux groupes CH présent(s) dans le groupe phényle peut/peuvent être remplacé (s) par N) et
(c) un groupe naphthyle (un ou deux groupes CH présent(s) dans le groupe naphthyle peut/peuvent être remplacé (s) par N)

et
les groupes compris en (a), (b) et (c) peuvent être substitués par un groupe alkyle ou un atome d'halogène, et
Ln représente un atome de métal des terres rares.

2. Complexe des terres rares optiquement actif selon la revendication 1, dans lequel, dans la formule générale (1), $X_1$ et $X_2$ sont des atomes d'hydrogène.

3. Complexe des terres rares optiquement actif selon la revendication 1, dans lequel, dans la formule générale (1), $Y_1$, $Y_2$, $Y_3$ et $Y_4$ sont des atomes d'hydrogène.

4. Complexe des terres rares optiquement actif selon la revendication 1, dans lequel, dans la formule générale (1), Ln est l'un d'Eu et Yb.

5. Complexe des terres rares optiquement actif selon la revendication 1, dans lequel, dans la formule générale (1), $R_1$ est un groupe trifluorométhyle.

6. Complexe des terres rares optiquement actif selon la revendication 1, dans lequel, dans la formule générale (1), $R_2$ est un groupe thienyle.

7. Complexe des terres rares optiquement actif selon la revendication 1, dans lequel la pureté optique du composé représenté par la formule générale (1) est au moins 70% ee.

8. Complexe des terres rares optiquement actif selon la revendication 1, dans lequel la pureté optique du composé représenté par la formule générale (1) est au moins 90% ee.

FIG.1

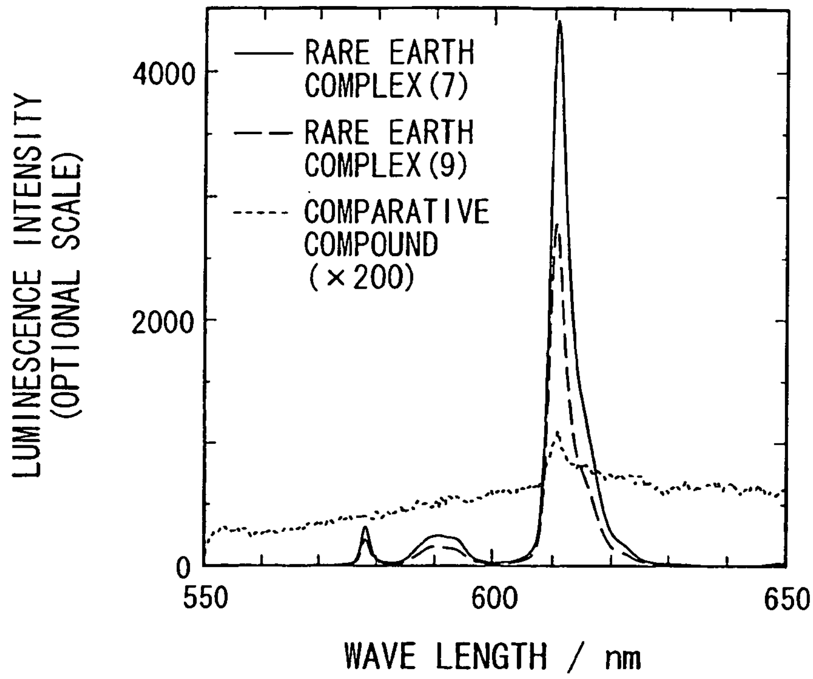
RARE EARTH COMPLEX (7)
RARE EARTH COMPLEX (9)
COMPARATIVE COMPOUND (×200)
LUMINESCENCE INTENSITY (OPTIONAL SCALE)
4000
2000
0
550
600
650
WAVE LENGTH / nm

FIG.2

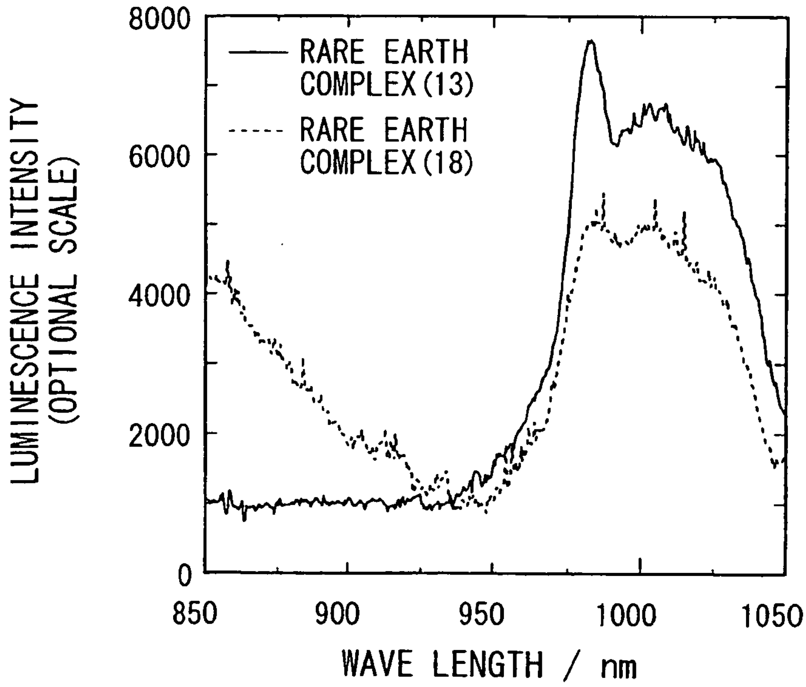
RARE EARTH COMPLEX (13)
RARE EARTH COMPLEX (18)
LUMINESCENCE INTENSITY (OPTIONAL SCALE)
8000
6000
4000
2000
0
850
900
950
1000
1050
WAVE LENGTH / nm

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP SHO5422336 B
- JP 2000204363 A
- JP 2002151251 A
- JP 2003143292 A
- JP 2003327590 A


### Non-patent literature cited in the description


- *J. Am. Chem. Soc.,* 1976, vol. 98 (19), 5858-5863
- *Org. Synth., Coll.,* 1993, vol. 8, 57